Europäisches Patentamt

(19) European Patent Office

Office européen des brevets

(11) Numéro de publication : **0 259 419 B1**

(12) **FASCICULE DE BREVET EUROPEEN**

(45) Date de publication du fascicule du brevet :
29.05.91 Bulletin 91/22

(51) Int. Cl.⁵ : **H03D 3/00**

(21) Numéro de dépôt : 87901516.2

(22) Date de dépôt : 09.03.87

(86) Numéro de dépôt international :
**PCT/FR87/00061**

(87) Numéro de publication internationale :
**WO 87/05758 24.09.87 Gazette 87/21**

(54) **DOUBLE DEMODULATEUR NUMERIQUE.**

(30) Priorité : 13.03.86 FR 8603582

(43) Date de publication de la demande :
16.03.88 Bulletin 88/11

(45) Mention de la délivrance du brevet :
29.05.91 Bulletin 91/22

(84) Etats contractants désignés :
**DE GB NL SE**

(56) Documents cités :
EP-A- 0 029 376
EP-A- 0 046 103
EP-A- 0 068 571
EP-A- 0 068 579
EP-A- 0 074 858
EP-A- 0 107 884
EP-A- 0 166 806
US-A- 4 090 145

(73) Titulaire : **ETAT FRANCAIS représenté par le Ministre des PTT (Centre National d'Etudes des Télécommunications)**
**38-40 rue du Général Leclerc**
**F-92131 Issy-les-Moulineaux (FR)**
Titulaire : **TELEDIFFUSION DE FRANCE**
**10, rue d'Oradour sur Glane**
**F-75932 Paris Cédex 15 (FR)**

(72) Inventeur : **CHASSAING, Françoise**
**24,rue des Bersaudières La Chapelle des Fougeretz**
**F-35520 Melesse (FR)**
Inventeur : **CHATEL, Jean**
**8, allée Emile Maurice**
**F-35000 Rennes (FR)**
Inventeur : **LETERTRE, Bernard**
**App. 1502 24, rue du Bourbonnais**
**F-35000 Rennes (FR)**

(74) Mandataire : **Mongrédien, André et al**
**c/o BREVATOME 25, rue de Ponthieu**
**F-75008 Paris (FR)**

## Description

La présente invention a pour objet un double démodulateur numérique.

L'invention s'applique à des signaux transportant une information sur onde porteuse modulée en fréquence, en amplitude, ou en phase. Sous réserve de compatibilité spectrale des modulations, elle s'applique également à des signaux modulés à la fois en amplitude et en fréquence, ou en amplitude et en phase ou à des signaux à double modulation d'amplitude en quadrature et à porteuse supprimée.

L'invention s'applique ainsi, notamment, aux signaux de télévision, en particulier à la démodulation du signal de chrominance des signaux composites qui, dans le cas du système SECAM, est modulé en fréquence, et qui, dans le cas des systèmes PAL et NTSC, a subi une double modulation d'amplitude en quadrature. Elle s'applique aussi à la démodulation des signaux modulés en fréquence utilisés dans les magnétoscopes. Elle s'applique encore à la démodulation des signaux utilisés en radiophonie et en transmission de données, que les modulations soient à plusieurs états de phase, de fréquence ou d'amplitude. Les performances obtenues permettent en outre des applications en métrologie, entre autres pour des mesures de fréquence instantanée ou non.

Les techniques antérieures les plus connues de démodulation de fréquence sont de type analogique. Parmi les plus anciennes, on peut citer les discriminateurs de phase ou de rapport. On connaît également des systèmes dont le fonctionnement repose sur une mesure de période, que ce soit par comptage ou par mesure de charge de capacité. Ces techniques, bien que relativement satisfaisantes, ont pour inconvénient de conduire à des systèmes nécessitant des réglages parfois délicats, de ne tolérer que des signaux de largeur de bande assez limitée et d'être inadaptées à un environnement de traitement numérique des signaux démodulés.

Des techniques numériques vouées à ce type de démodulation sont apparues plus récemment, mais jusqu'à présent aucune ne conduit à des résultats vraiment satisfaisants. Les différents algorithmes connus sont les suivants :

### 1. Algorithmes d'approximation :

– algorithme dit en "Arc tangente" dans lequel, le signal étant échantillonné au voisinage de quatre fois la fréquence porteuse, on effectue une estimation de la position du vecteur tournant qui lui est associé par calcul de l'arc tangente du rapport de deux échantillons approximativement en quadrature. Cette méthode, peu précise, a pour inconvénient d'être très liée à la fréquence d'échantillonnage utilisée et de ne permettre la démodulation que dans une bande de fréquence réduite. Une telle technique est décrite par exemple dans le document FR-A-2 488 755.

– algorithme d'estimation des points de passage par zéro, dans lequel, à partir de deux échantillons du signal modulé de signes opposés, on estime, par une méthode d'interpolation, l'instant auquel la porteuse s'annule, à la suite de quoi on calcule la période du signal. Cette méthode nécessite une fréquence d'échantillonnage très élevée. Elle est peu précise, le résultat étant très dépendant de la quantification du signal à démoduler.

### 2. Algorithme à division :

Cette technique repose sur la division de sommes pondérées d'échantillons successifs du signal. Bien que théoriquement exacts, des calculs de ce type posent des problèmes de précision et de stabilité pour les faibles valeurs du diviseur. On est ainsi amené à éliminer les résultats obtenus lorsque le diviseur est trop petit et à leur substituer des résultats estimés à partir de ceux qui précèdent ou suivent immédiatement la valeur recherchée. Il en résulte toujours un signal démodulé entaché d'imprécision et qui, en règle générale, est extrêmement bruité. Une telle technique est décrite par exemple dans le document FR-A-2 469 824 et EP-A-9 107884, EP-A-00 68571 et EP-A-00 68579.

### 3. Algorithme à multiplication :

Ils sont la transposition d'une méthode utilisée en analogique selon laquelle on effectue un produit entre le signal modulé et ce même signal passé au travers d'une ligne à retard. Le signal modulant est extrait de ce résultat par filtrage passe-bas. En analogique où, avant démodulation, le signal passe au travers d'un limiteur, cette méthode donne de bons résultats. En numérique, la fonction limitation n'a pas de sens, il s'ensuit que le signal démodulé selon cette méthode est perturbé par toutes les distorsions d'amplitude du signal modulé. Là encore, le résultat peut être extrêmement bruité.

En ce qui concerne la démodulation d'amplitude, les méthodes les plus connues sont mises en oeuvre elles

2

aussi avec des circuits analogiques. Les plus sophistiquées d'entre elles sont les démodulations dites synchrones pour lesquelles la fréquence porteuse, qu'elle ait été transmise ou non, est restituée au niveau du démodulateur. Le produit entre cette onde et le signal à démoduler permet, après filtrage passe-bas, d'extraire le signal modulant.

Les méthodes numériques connues sont une simple transposition de ces techniques analogiques. Elles conduisent à de bons résultats, mais nécessitent toutefois la réalisation de filtres passe-bas de mise en oeuvre assez complexe.

Le but de l'invention est de proposer un démodulateur qui permet, sans réglage, et dans des conditions de performances élevées et stables :

– une démodulation de fréquence,
– une démodulation d'amplitude,
– une démodulation de fréquence et d'amplitude simultanées ou un contrôle d'amplitude du signal modulé en fréquence,
– sur la même structure de base, la démodulation d'amplitude dans le cas d'une modulation d'amplitude double en quadrature à porteuse supprimée,
– la démodulation de phase,
– moyennant l'adjonction d'une simple commutation, d'effectuer une démodulation de fréquence ou une démodulation d'amplitude double ; cette dernière possibilité s'applique en particulier eux décodeurs de signaux de télévision fonctionnant indifféremment en NTSC, en PAL ou en SECAM.

Lorsqu'il fonctionne en démodulateur de fréquence, le système proposé s'avère très performant en terme de rapport signal à bruit du signal de sortie et est insensible eux distorsions du signal d'entrée. Il supporte une perte de 20dB de l'amplitude du signal d'entrée et des distorsions dans les réponses amplitude-fréquence des circuits précédents. La stabilité du résultat est garantie en tout point et l'on n'a jamais à faire appel à des dispositifs de masquage de résultats imprécis. La linéarité du démodulateur est en outre parfaitement maîtrisée: elle est susceptibLe d'être rigoureusement linéaire ou de compenser avec précision une caractéristique tension-fréquence qui, au niveau du modulateur, serait non linéaire.

Lorsqu'il fonctionne en démodulation d'amplitude, le système proposé dans la présente invention s'avère aussi performant qu'un système fonctionnant sur la base d'un algorithme conventionnel, sans toutefois nécessiter la mise en oeuvre de filtres passe-bas pour extraire le signal démodulé.

Le démodulateur proposé a fait l'objet d'une étude approfondie dans le cas des signaux de chrominance utilisés dans les systèmes de télévision en couleur PAL et SECAM, qui sont respectivement modulés en amplitude (double modulation en quadrature à porteuse supprimées) et en fréquence. Les performances obtenues sont identiques pour les deux systèmes, et, pour le système PAL, légèrement supérieures à celles qui sont obtenues avec des moyens conventionnels.

Le démodulateur de l'invention est double en ce sens qu'il peut traiter deux types de signaux modulés : des signaux modulés en fréquence et en phase ou en amplitude et des signaux ayant fait l'objet d'une double modulation d'amplitude en quadrature et à porteuse supprimée. Un démodulateur double de ce type est connu par exemple du document EP-A-0074858.

Dans le démodulateur selon l'invention, on passe d'un traitement à un autre en faisant basculer des dispositifs de commutation. Ces dispositifs de commutation ont deux entrées, l'une utilisée pour la démodulation de fréquence (ou de phase) et d'amplitude, et l'autre pour la double démodulation d'amplitude à porteuse supprimée. Mais les deux traitements mettent en oeuvre des moyens communs qui sont constitués tout d'abord par un transformateur de Hilbert, qui reçoit la suite des échantillons du signal modulé et délivre deux suites d'échantillons en quadrature, puis des multiplieurs qui permettent d'effectuer des produits entre échantillons du signal ou échantillons de sous-porteuses, et enfin des additionneurs, qui effectuent des sommes (ou des différences) de ces produits.

De toute façon, les caractéristiques de l'invention apparaîtront mieux à la lumière de la description qui va suivre, d'exemples de réalisation donnés à titre explicatif et nullement limitatif. Cette description se réfère à des dessins annexés, sur lesquels :

– la figure 1 représente le schéma général du double démodulateur de l'invention,
– la figure 2 montre, dans le cas d'une démodulation de fréquence, un premier sous-ensemble capable de calculer des quantités Eo(n) et M(n),
– la figure 3 montre un deuxième sous-ensemble capable de calculer la quantité E1(n) et M(n),
– la figure 4 montre un premier mode de réalisation d'un sous-ensemble d'extraction du signal démodulé à partir des signaux E(n) et M(n),
– la figure 5 montre un deuxième mode de réalisation d'un sous-ensemble d'extraction du signal démodulé,
– la figure 6 montre un troisième mode de réalisation d'un sous-ensemble d'extraction du signal démodulé,
– la figure 7 illustre un montage permettant d'obtenir l'amplitude du signal d'entrée,

3

– la figure 8 montre un sous-ensemble d'extraction du signal modulant dans le cas d'une démodulation de phase,

– la figure 9 montre la structure du démodulateur dans le cas d'une démodulation de signaux à double modulation en quadrature et à porteuse supprimée,

– la figure 10 montre la réponse amplitude-fréquence d'un transformateur de Hilbert,

– la figure 11 montre un moyen permettant la multiplication d'une donnée par un coefficient au moyen d'un additionneur,

– la figure 12 montre un premier mode de réalisation d'un transformateur de Hilbert,

– la figure 13 montre un deuxième mode de réalisation d'un transformateur de Hilbert,

– la figure 14 montre un troisième mode de réalisation d'un transformateur de Hilbert,

– la figure 15 montre un quatrième mode de réalisation d'un transformateur de Hilbert,

– la figure 16 montre un cinquième mode de réalisation d'un transformateur de Hilbert,

– la figure 17 montre un sixième mode de réalisation d'un transformateur de Hilbert.

Avant de décrire la structure du démodulateur de l'invention, quelques considérations théoriques vont être développées à propos de la forme que prennent les signaux selon les différentes modulations possibles.

Tout d'abord, en ce qui concerne la modulation de fréquence, on rappelle qu'une onde modulée en fréquence s'exprime de manière générale sous la forme :

$$s(t) = A \cdot \cos 2\pi (f_0 t + \Delta f_0 \int_0^t m(u) du)$$

avec pour paramètres :

$A$ = amplitude du signal modulé,

$f_0$ = fréquence de repos du modulateur,

$\Delta f_0$ = excursion de fréquence du modulateur

$m(t)$ = signal modulant.

Sous forme échantillonnée, $T$ représentant la période d'échantillonnage, cette expression devient :

$$s(nT) = A \cdot \cos 2\pi (f_0 nT + k\Delta f_0 T \sum_0^n m(nT))$$

soit encore :

$$s(nT) = A \cdot \cos \varphi(nT) \quad (R1)$$

avec :

$$\varphi(nT) = 2\pi T (nf_0 + k\Delta f_0 \sum_0^n m(nT))$$

On remarque que la phase $\varphi(nT)$, que l'on désignera par la suite par $\varphi(n)$, peut prendre une forme récursive :

$$\varphi(nT) = \varphi(n-1) + \Delta\varphi(n)$$

avec :

$$\Delta\varphi(n) = 2\pi T(f_0 + k\Delta f_0 \cdot m(n)) \quad (R2)$$

$\Delta\varphi(n)$ représente l'incrément de phase de l'onde modulée en fréquence pendant chaque période d'échantillonnage.

Pour respecter le théorème d'échantillonnage, $\Delta\varphi(n)$ devra rester compris entre 0 (signal continu) et $\pi$ (signal à fréquence moitié de la fréquence d'échantillonnage).

Compte tenu du caractère biunivoque de la relation R2, pour connaître la valeur du signal modulant m(n) à l'instant t = nT, il suffira de déterminer $\Delta\varphi(n)$ et réciproquement.

Pour ce qui est de la démodulation de fréquence, on peut faire les remarques suivantes.

Il s'agit de traiter un signal analogique de la forme :

$$s(t) = A(t) \cdot \cos\varphi(t)$$

Dans cette expression le terme A(t) représente l'amplitude du signal modulé, qui, au niveau de la réception, est susceptible de fluctuer au cours du temps du fait de perturbations d'origines diverses telles que variation de la puissance reçue, distorsions des réponses amplitude-fréquence des circuits précédents, etc.. Le signal s(t) est appliqué à un convertisseur analogique numérique qui l'échantillonne à tous les instants t = nT et le numérise avec un nombre approprié d'éléments binaires. Il en sort la séquence ; s(n) = A(n)cos$\varphi$(n) qui est traitée par le démodulateur de l'invention.

Dans le dispositif de l'invention, cette séquence est d'abord appliquée à un transformateur de Hilbert pour disposer de deux versions en quadrature du signal modulé. On aura ainsi sur chacune des sorties respectivement.

$$x(n) = A(n) \cdot \cos\varphi(n) \text{ et } y(n) = A(n) \cdot \sin\varphi(n)$$

et pour l'échantillon suivant :

$$x(n+1) = A(n+1) \cdot \cos(\varphi(n)+\Delta\varphi(n+1))$$

$$\text{et } y(n+1) = A(n+1) \cdot \sin(\varphi(n)+\Delta\varphi(n+1))$$

$\Delta\varphi(n+1)$ représentant l'incrément de phase entre les échantillons n et n+1.

A partir de ces quatre expressions, il est possible de calculer diverses quantités $E_0(n)$, $E_1(n)$ et m(n) :

$$E_0(n) = x(n)\, y(n+1) - y(n)\, x(n+1) \quad (R4)$$

soit.

$$E_0(n) = A(n)\, A(n+1)[\sin(\varphi(n) + \Delta\varphi(n+1)) \cdot \cos\varphi(n) - \sin\varphi(n) \cdot \cos(\varphi(n) + \Delta\varphi(n+1))]$$

soit finalement :

$$E_0(n) = A(n)\, A(n+1) \cdot \sin \Delta\varphi(n+1)$$

ou encore l'expression :

$$E_1(n) = x(n) \cdot x(n+1) + y(n) \cdot y(n+1) \quad (R5)$$

soit :

$$E_1(n) = A(n)\, A(n+1)[\cos\varphi(n) \cdot \cos(\varphi(n) + \Delta\varphi(n+1))+\sin\varphi(n) \cdot \sin(\varphi(n) + \Delta\varphi(n+1))]$$

soit finalement :

$$E_1(n) = A(n)\, A(n+1) \cdot \cos\Delta\varphi(n+1)$$

Selon l'expression retenue, on peut ainsi disposer de l'incrément $\Delta\varphi$ par l'intermédiaire de son sinus ou de son cosinus affecté d'un coefficient sensiblement égal au carré de l'amplitude du signal modulé. On peut alors calculer :

$$M(n) = x^2(n) + y^2(n) \quad (R6)$$

$$M(n) = A^2(n)(\cos^2\varphi(n) + \sin^2\varphi(n))$$

$$M(n) = A^2(n) \quad \text{ou} \quad A(n) = \sqrt{M(n)}$$

Ceci étant, il vient :

$$\sin \Delta\varphi(n+1) = \frac{E_0(n)}{\sqrt{M(n).M(n+1)}} \simeq \frac{E_0(n)}{M(n)} \simeq \frac{E_0(n)}{M(n+1)} \quad (R7)$$

ou encore :

$$\cos \Delta\varphi(n+1) = \frac{E_1(n)}{\sqrt{M(n)\,M(n+1)}} \simeq \frac{E_1(n)}{M(n)} \simeq \frac{E_1(n)}{M(n+1)} \quad (R8)$$

Selon le cas on pourra extraire le signal modulant par l'une ou l'autre des relations :

$$m(n) = \frac{1}{k\Delta f_0} \left[ \frac{1}{2\pi T} . \text{Arc sin} \left( \frac{E_0(n)}{M(n)} \right) - f_0 \right] \quad (R9)$$

$$m(n) = \frac{1}{k\Delta f_0} \left[ \frac{1}{2\pi T} . \text{Arc cos} \left( \frac{E_1(n)}{M(n)} \right) - f_0 \right] \quad (R10)$$

En résumé, partant d'un signal s(n) numérisé dont on détermine deux versions x(n) et y(n) en quadrature, on est amené à calculer une quantité E(n) (soit sous la forme $E_0(n)$ soit sous la forme $E_1(n)$) et une quantité M(n). Le quotient de ces deux quantités conduit immédiatement à la valeur du signal modulant recherché.

En ce qui concerne maintenant la démodulation d'amplitude ou de phase pour des signaux à double modulation en quadrature et à porteuse supprimée, on rappelle que l'onde modulée a pour expression :

$$s(t) = U(t)\cos\omega t + V(t)\sin\omega t = A(t) \cdot \cos(\omega t - \theta(t))$$

où U(t) et V(t) sont deux composantes de modulation d'amplitude qui modulent chacune une porteuse. Ces deux porteuses sont de même fréquence mais déphasées de 90°.

Les deux composantes de modulation peuvent être considérées comme indépendantes ou comme étant les projections orthogonales d'un vecteur de longueur A(t) faisant un angle $\theta(t)$ par rapport à une référence. Le problème de la démodulation sera donc de déterminer l'un des couples U(t), V(t) ou A(t), $\theta(t)$. Sous forme échantillonnée, l'expression de l'onde modulée devient :

$$s(nT) = U(nT)\cos n\omega T + V(nT)\sin n\omega T = A(nT)\cos(n\omega T - \theta(nT))$$

Pour démoduler un signal de ce type, il est nécessaire de disposer d'une référence pour régénérer la porteuse, et plus précisément pour régénérer deux sous-porteuses en quadrature : X(n)=A cos n$\omega$T et Y(n)=A sin n$\omega$T.

Le signal s(nT) peut alors être appliqué à un transformateur de Hilbert qui en délivre deux versions x(n) et y(n) en quadrature comme pour la démodulation de fréquence envisagée plus haut. En supposant la quadrature arrière, il vient :

$$x(n) = U(n) \cos n\omega T + V(n) \sin n\omega T$$

$$y(n) = U(n) \cos (n\omega T - \pi/2) + V(n) \sin (n\omega T - \pi/2)$$

$$y(n) = U(n) \sin n\, T - V(n) \cos n\, T.$$

On montre aisément que l'on peut en extraire U(n) et V(n) moyennant les opérations suivantes :

$$A \cdot U(n) = X(n) + y(n)\, Y(n) \quad \text{(R11)}$$

$$A \cdot V(n) = x(n)\, Y(n) - y(n)\, X(n) \quad \text{(R12)}$$

Ayant déterminé U(n) ou V(n), on peut, si on le souhaite, déterminer A(n) et $\theta(n)$ du fait que U(n)=A(n) cos$\theta(n)$ et que V(n)=A(n) sin$\theta(n)$. Les quantités U(n) et V(n) sont alors appliquées soit à une mémoire morte équivalente à une table, soit à un système de calcul qui délivre l'information sous la forme A(n), $\theta(n)$.

Ces considérations théoriques ayant été exposées, la structure du dispositif de l'invention peut être décrite.

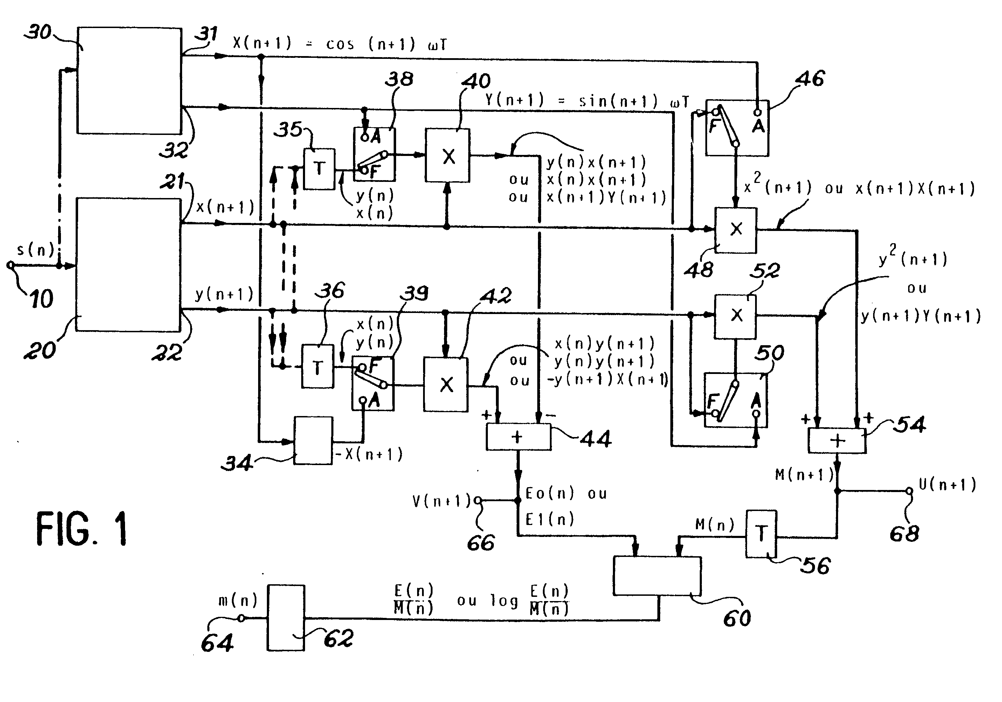

La figure 1 tout d'abord illustre la structure générale du dispositif. Le double démodulateur numérique représenté comprend :

– une entrée générale 10 recevant les échantillons numériques s(n) d'un signal modulé, où $\underline{n}$ est le rang de l'échantillon,

– un transformateur de Hilbert 20 ayant une entrée reliée à l'entrée générale 10 et une première et une seconde sorties 21, 22 délivrant respectivement des échantillons en quadrature x(n+1) et y(n+1),

– un circuit de régénération de porteuse 30 ayant une entrée reliée à l'entrée générale 10 et une première et une seconde sorties 31, 32 délivrant des sous-porteuses en quadrature x(n+1) et y(n+1),

– une première ligne à retard 35 reliée à l'une des deux sorties 21 ou 22 du transformateur de Hilbert 20 et délivrant un échantillon retardé x(n) ou y(n) d'une période d'échantillonnage,

– une seconde ligne à retard 36 reliée à l'autre sortie 22 du transformateur de Hilbert 20 et délivrant un échantillon retardé y(n) ou x(n) d'une période d'échantillonnage,

– un premier dispositif de commutation 38 ayant une première entrée A reliée à la seconde sortie 32 du circuit de régénération de porteuse 30, une seconde entrée F reliée à la première ligne à retard 35 et une sortie,

– un second dispositif de commutation 39 ayant une première entrée A reliée, par l'intermédiaire d'un inverseur 34, à la première sortie 31 du circuit de régénération de porteuse 30, une seconde entrée F reliée à la seconde ligne à retard 36 et une sortie S,

– un premier multiplieur 40 ayant une première entrée reliée à la sortie du premier dispositif de commutation 38 et recevant l'échantillon x(n) ou y(n) ou la sous-porteuse Y(n+1), et une seconde entrée reliée à la première sortie 21 du transformateur de Hilbert 20 et recevant l'échantillon x(n+1), ce premier multiplieur ayant une sortie délivrant l'un des produits y(n)x(n+1), x(n)x(n+1), x(n+1)Y(n+1),

– un second multiplieur 42 ayant une première entrée reliée à la sortie du second dispositif de commutation 39 et recevant l'échantillon y(n) ou x(n) ou la sous-porteuse X(n+1) et une seconde entrée reliée à la seconde sortie 22 du transformateur de Hilbert 20 et recevant l'échantillon y(n+1), ce second multiplieur 42 ayant une sortie délivrant l'un des produits x(n)y(n+1), y(n)y(n+1), –y(n+1)X(n+1),

– un premier additionneur 44 ayant une première entrée reliée à la sortie du premier multiplieur 40 et une seconde entrée pouvant être inverseuse et reliée à la sortie du second multiplieur 42, ce premier additionneur ayant une sortie délivrant un signal $E_0(n)$ ou $E_1(n)$ ou V(n+1),

– un troisième dispositif de commutation 46 ayant une première entrée F reliée à la première sortie 21 du transformateur de Hilbert 20 et une seconde entrée A reliée à la première sortie 31 du circuit de régénération de porteuse 30, et une sortie,

– un troisième multiplieur 48 ayant une première entrée reliée à la première sortie 21 du transformateur de Hilbert 20, une seconde entrée reliée à la sortie du troisième dispositif de commutation 46 et une sortie délivrant soit $x^2(n+1)$, soit x(n+1)X(n+1),

– un quatrième dispositif de commutation 50 ayant une première entrée F reliée à la seconde sortie 22 du transformateur de Hilbert 20, une seconde entrée reliée à la seconde sortie 32 du circuit de régénération de porteuse 30 et une sortie,

– un quatrième multiplieur 52 ayant une première entrée reliée à la seconde sortie 22 du transformateur de Hilbert 20, une seconde entrée reliée à la sortie du quatrième dispositif de commutation 50 et une sortie délivrant soit y(n+1), soit y(n+1)Y(n+1),

– un second additionneur 54 ayant une première entrée reliée à la sortie du troisième multiplieur 48, une seconde entrée reliée à la sortie du quatrième multiplieur 52 et une sortie délivrant une quantité M(n+1), ou U(n+1),

– éventuellement une troisième ligne à retard 56 d'une periode d'échantillonnage reliée au second additionneur 54 et délivrant le signal M(n),

– un circuit diviseur 60 ayant une première entrée reliée à la sortie du premier additionneur 44 et recevant un signal $E_0(n)$ ou $E_1(n)$, une seconde entrée reliée à la troisième ligne à retard 56 ou, si celle-ci n'existe pas, au second additionneur 54 et recevant le signal M(n) et une sortie délivrant un signal quotient de $E_0(n)$ ou $E_1(n)$ par M(n),

– un circuit de sortie 62 ayant une entrée adressée par le signal apparaissant à la sortie du circuit diviseur 60 et une sortie.

Un tel démodulateur est capable de démoduler :

– soit un signal s(n) modulé en fréquence par un signal modulant m(n), auquel cas les quatre dispositifs de commutation 38, 39, 46, 50 sont dans la position qui relie leur sortie à leur première entrée F, le signal modulant m(n) étant alors disponible sur une sortie générale 64 reliée à la sortie du circuit de sotie 62,

– soit un signal à double modulation d'amplitude U(n), V(n) en quadrature et à porteuse supprimée, auquel cas les quatre dispositifs de commutation 38, 39, 46, 50 sont dans la position qui relie leur sortie à leur seconde entrée A, les signaux démodulés V(n+1) et U(n+1) étant disponibles sur deux sorties générales 66, 68 correspondant respectivement à la sortie du premier 44 et du second 54 additionneurs.

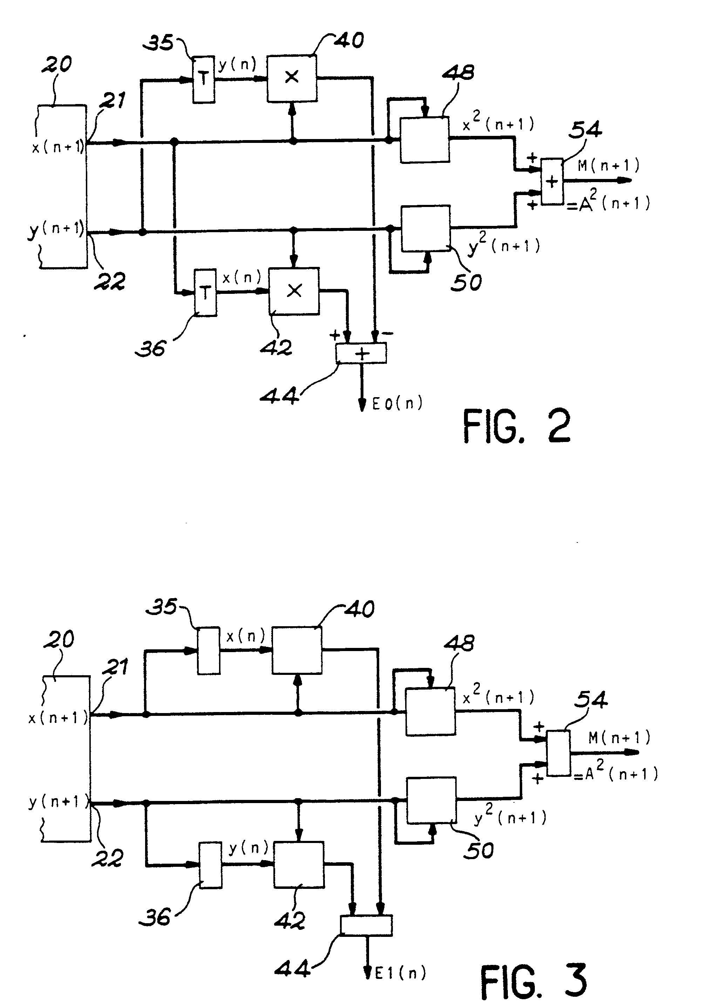

Selon le type de démodulation à effectuer, la structure du démodulateur prend diverses formes dont les deux qui sont illustrées sur les figures 2 et 3. Il s'agit du cas où le circuit effectue une démodulation de fréquence. Les dispositifs de commutation 38, 39, 46 et 50 sont donc sur la position F.

Sur la figure 2, on retrouve le transformateur de Hilbert 20, les lignes à retard 35, 36, les multiplieurs 40, 42, 48, 50 et les additionneurs 44, 54.

L'additionneur 44 reçoit le produit x(n)y(n+1) sur son entrée non inverseuse et le produit y(n)x(x+1) sur son entrée Inverseuse. Il délivre par conséquent la quantité :

$$x(n)y(n+1)-y(n)x(n+1)$$

c'est-à-dire la quantité $E_0(n)$ définie plus haut par la relation R4.

De même, l'additionneur 54 reçoit $x^2(n+1)$ et $y^2(n+1)$ et délivre la quantité $x^2(n+1)+y^2(n+1)$, soit M(n+1) selon la relation R6, soit encore $A^2(n+1)$.

Sur la figure 3, les moyens sont les mêmes, mais les lignes à retard 35 et 36 sont connectées respectivement aux sorties 21 et 22. L'additionneur-soustracteur 44 reçoit les produits y(n)y(n+1) et x(n)x(n+1). Dans ce cas, il n'y pas d'entrée inverseuse. Le signal de sortie est la somme :

$$x(n)x(n+1)+y(n)y(n+1)$$

c'est-à-dire $E_1(n)$ conformément à la relation R5.

Quant à l'additionneur 54, il reçoit $x^2(n+1)$ et $y^2(n+1)$

et délivre donc M(n+1) ou encore $A^2(n+1)$,

Dans ces deux dispositifs, les circuits 48 et 50 d'élévation au carré peuvent être des multiplieurs ou des mémoires mortes.

Le circuit de la figure 2 permet donc de calculer la quantité sin $\Delta\varphi$ et le circuit de la figure 3 la quantité cos $\Delta\varphi$.

Pour la plupart des applications, la structure donnée à la figure 3 constitue une réalisation préférentielle. Ceci tient au fait qu'elle conduit au calcul de cos $\Delta\varphi$ qui, pour une quantification donnée, permet de déterminer $\Delta\varphi$ et donc m avec davantage de précision qu'à partir de sin $\Delta\varphi$ pour toutes les fréquences du signal modulé d'entrée comprise entre fe/8 et 3fe/8, fe désignant la fréquence d'échantillonnage.

L'algorithme conduisant au calcul de sin $\Delta\varphi$ suppose par ailleurs une connaissance a priori de $\Delta\varphi$ pour savoir si cette quantité est supérieure ou inférieure à 90° et si donc la fréquence estimée est supérieure ou inférieure à fe/4.

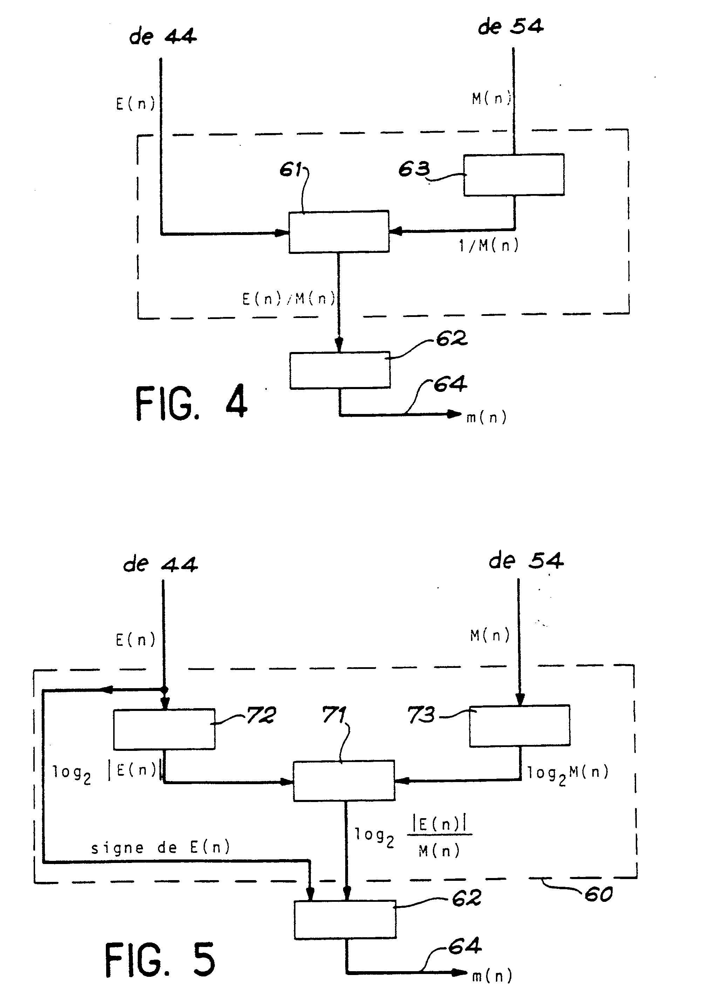

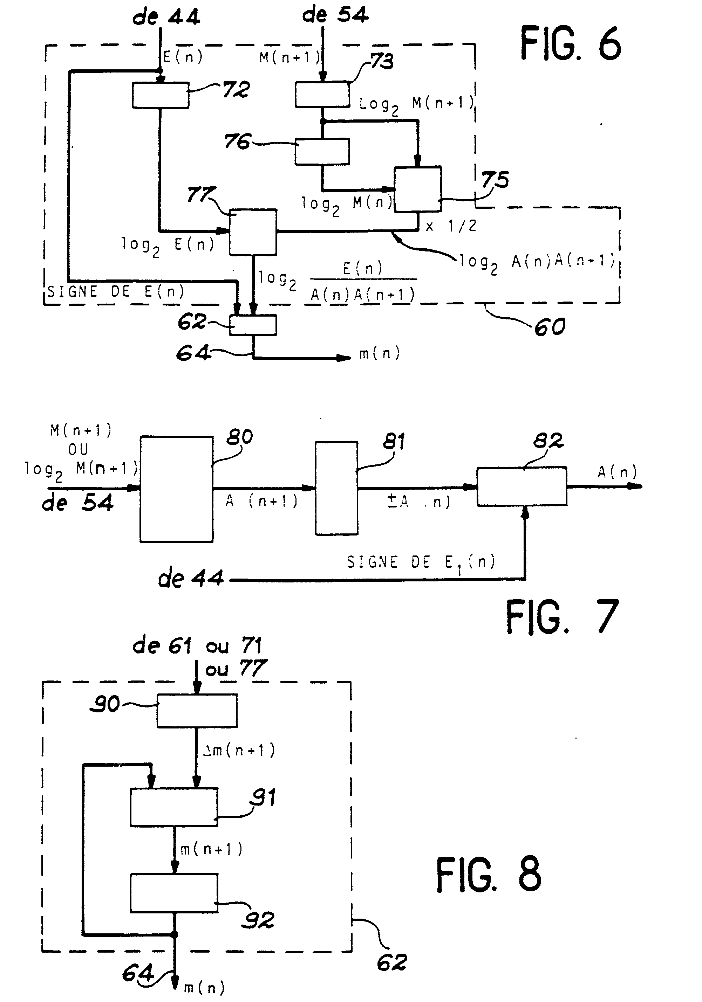

Disposant de E(n) (c'est-à-dire soit de $E_0(n)$, soit de $E_1(n)$ et de M(n), il faut diviser la première quantité par la seconde, puis en déduire m(n). Pour cela deux types de dispositifs peuvent conduire au résultat selon que l'on effectue un produit (figure 4) ou que l'on utilise des logarithmes (figures 5 et 6).

Le circuit de la figure 4 est un sous-ensemble qui comporte un multiplieur 61 effectuant le produit de E(n) par 1/M(n), des mémoires mortes, l'une 63 recevant M(n) pour adresse et contenant les quantités 1/M(n), l'autre 62 recevant E(n)/M(n) pour adresse et contenant les valeurs de m(n) telles que les donnent les relations R9 ou R10.

8

La figure 5 représente une variante de ce sous-ensemble qui comporte un additionneur 71 effectuant la soustraction de $\log_2 E(n)$ et de $\log_2 M(n)$, des mémoires mortes :

– les unes 72, 73 recevant E(n) ou M(n) pour adresses et contenant les logarithmes à base 2 des valeurs absolues de ces quantités,

– l'autre 62 recevant $\log_2[|E(n)|/M(n)]$ pour adresse et contenant les valeurs m(n) selon l'une ou l'autre des relations :

$$\frac{1}{k\,\Delta\,f_0}\left[\frac{1}{2\,\pi\,T}\,\text{Arc sin }(2^{\log_2}\frac{E_0(n)}{M(n)}) - f_0\right]$$

$$\frac{1}{k\,\Delta\,f_0}\left[\frac{1}{2\,\pi\,T}\,\text{Arc cos }(2^{\log_2}\frac{E_1(n)}{M(n)}) - f_0\right]\ \text{si } E_1(n) > 0$$

$$\frac{1}{k\,\Delta\,f_0}\left[\frac{1}{2\,\pi\,T}\,(\pi - \text{Arc cos }(2^{\log_2}\frac{E_1(n)}{M(n)})) - f_0\right]\ \text{si } E_1(n) < 0$$

Dans l'hyporthèse où l'on utilise $E_1(n)$ comme valeur de E(n), la mémoire morte 62 qui délivre m(n) reçoit en outre le signe de $E_1(n)$ dans la mesure où une connaissance a priori de la fréquence à démoduler (f > fe/4 ou f < fe/4) ne permettrait pas de dire par avance si $\Delta\varphi$ est supérieur ou inférieur à 90°.

La figure 6 montre une variante de l'invention qui repose sur la même structure de base que celle qui est donnée à là figure 5. Elle comporte deux mémoires mortes 72, 73 délivrant les logarithmes de E(n) et M(n+1), un additionneur 75 et un registre 76 permettant de retarder le signal d'une période d'échantillonnage et un additionneur soustracteur 77.

L'additionneur 75 délivre la quantité :

$$1/2 < \log_2 M(n) + \log_2 M(n+1) >,$$

soit $\log_2 A(n)A(n+1)$.

L'additionneur soustracteur 77 délivre la quantité $\log_2 (E(n)/A(n)A(n+1))$. Le signal modulant m(n) peut donc être déterminé sur la base des expressions exactes, et non plus sur la base des relations approchées données par les relations R7 et R8.

Dans les circuits précédents, on obtient M(n) ou M(n+1), c'est-à-dire, en définitive, le carré de l'amplitude du signal d'entrée $A^2(n)$ ou $A^2(n+1)$. Dans le cas d'une démodulation d'amplitude, il suffit donc d'extraire l'information A(n) ; les moyens de calcul de $E_0(n)$ ou $E_1(n)$ sont alors inutiles. Par ailleurs, par l'intermédiaire de l'une ou l'autre des trois informations A(n), M(n) ou $\log_2 M(n)$, on dispose d'une information permettant de réagir sur l gain du signal d'entrée à un endroit quelconque de la chaîne précédant le transformateur de Hilbert, de façon à éviter la saturation des circuits de démodulation et à maintenir le niveau d'entrée ajusté au mieux des performances de ceux-ci,

Dans l'hypothèse d'une modulation d'amplitude à porteuse supprimée, le circuit proposé reste utilisable. On utilise alors l'information $E_1(n)$ et une connaissance a priori de la fréquence porteuse, donc de $\Delta\varphi$, pour déterminer le signe du signal démodulé A(n), qui, selon le cas, sera celui de $E_1(n)$ ou le signe opposé. Le montage est alors celui de la figure 7. Il comprend une mémoire morte 80 recevant M(n+1) du circuit 54 ou $\log_2 M(n+1)$ du circuit 73. Elle délivre A(n+1) qui est appliqué à une ligne à retard d'une période 81. Un multiplieur 82 permet de délivrer A(n) avec son signe correct, si on lui applique par ailleurs le signe de $E_1(n)$.

Dans l'hypothèse où une modulation de phase est substituée à la modulation de fréquence, l'expression de l'incrément de phase de l'onde modulée devient :

$$\Delta\varphi(n+1) = 2\pi f_0 T + k\varphi(m(n+1) - m(n)$$

$k\varphi$ représente la pente de la modulation.

La connaissance de $\Delta\varphi(n+1)$ conduit à celle d'un $\Delta m(n+1)$ tel que :

$$\Delta m(n+1) = m(n+1) - m(n) = 1/k\varphi(\Delta\varphi - 2\pi f_0 T)$$

Connaissant $\Delta m$, on en tire le signal modulant par $m(n+1) = m(n) + \Delta m(n+1)$,

Pour ce faire, on peut utiliser le circuit de la figure 8. Il comprend une mémoire morte 90 qui reçoit E(n)/M(n)

ou $\log_2$ (E(n)/M(n)) ou $\log_2$ (E(n)/A(n)A(n+1)) et délivre $\Delta$m(n+1). Le circuit comprend encore un accumulateur constitué d'un additionneur 91 et d'un registre à retard d'une période d'horloge 92 dont la sortie est rebouclée sur l'entrée de l'additionneur 91.

Après avoir décrit les divers modes de réalisation que peut prendre le circuit de l'invention dans le cas de la démodulation de fréquence, de phase ou d'amplitude, on va maintenant envisager le cas d'une démodulation d'amplitude pour des signaux à double démodulation en quadrature et à porteuse supprimée.

Comme expliqué plus haut, il est nécessaire, dans ce cas, de disposer de deux sous-porteuses en quadrature. Le circuit de régénération de porteuse 31 doit donc être mis en service. Cela s'obtient en faisant basculer les dispositifs de commutation 38, 39, 46, 50 pour connecter leur entrée A (et non plus F).

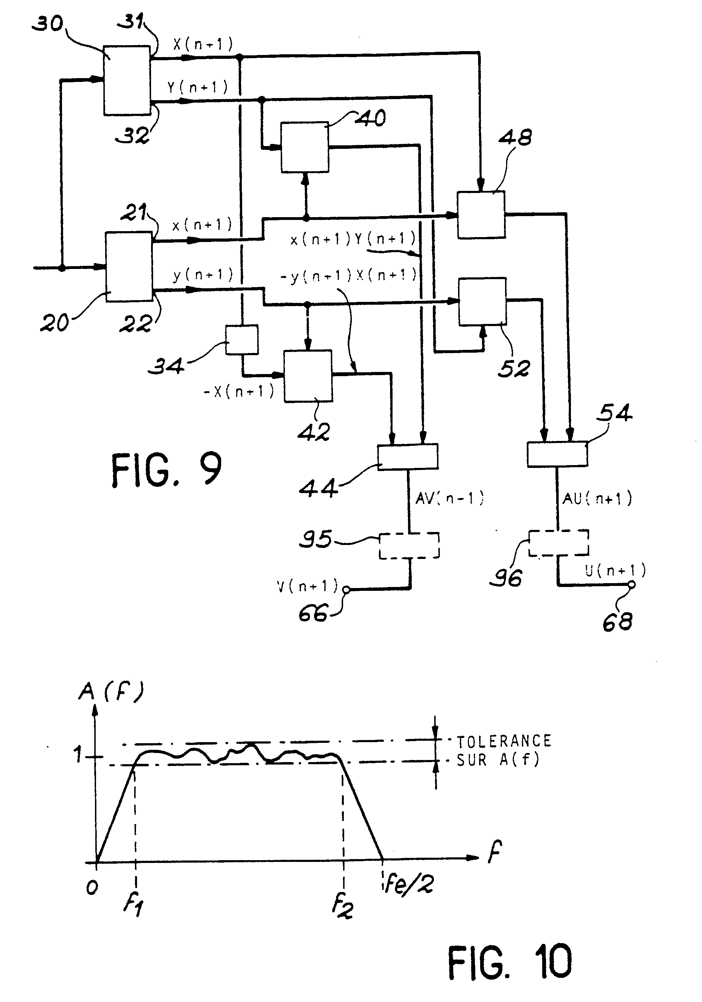

la figure 9 montre le circuit obtenu. On y retrouve le transformateur de Hilbert 20, le circuit de régénération de sous-porteuse 30, les multiplieurs 40, 42, 48, 52, l'inverseur 34 et les additionneurs 44 et 54, le multiplieur 40 délivre le produit x(n+1)Y(n+1), le multiplieur 42 le produit –y(n+1)X(n+1). l'additionneur 44 délivre donc la quantité x(n+1)Y(n+1)–y(n+1)X(n+1), c'est-à-dire AV(n+1) conformément à la relation R12.

De même, le multiplieur 48 délivre le produit x(n+1)X(n+1) et le multiplieur 52 le produit y(n+1)Y(n+1). l'additionneur 54 délivre la somme x(n+1)X(n+1)+y(n+1)y(n+1), soit AU(n+1) conformément à la relation R11.

On peut éventuellement ajouter au circuit des mémoires mortes 95 et 96 si l'on n'a pas pu faire en sorte que A soit égal à 1.

Dans toutes ses formes de réalisation, la présente invention comporte un dispositif 20 appelé transformateur de Hilbert. Celui-ci reçoit le signal d'entrée à démoduler et en délivre deux versions en quadrature. Ce dispositif consiste en un filtre numérique transversal dont la réponse amplitude-fréquence est aussi proche que possible de l'unité dans toute la bande utile du signal à démoduler.

Dans la présente invention, ce filtre numérique est caractérisé par le fait :

– qu'il a une réponse impulsionnelle de longueur finie,

– que le nombre total de ses coefficients est impair,

– que sa réponse impulsionnelle est impaire, autrement dit que les coefficients situés de part et d'autre du coeffcient central ont deux à deux même module mais sont de signes opposés ($a_i = -a_{-i}$).

– que tous les coefficients de rang pair sont nuls :

$$a_0 = a_{\pm 2} = a_{\pm 4} = a_{\pm 2p} = 0$$

La figure 10 donne une représentation de la réponse amplitude-fréquence. Les fréquences $f_1$ et $f_2$ dépendent des coefficients du transformateur et on a : $f_2 = (fe_{/2})-f_1$, fe désignant la fréquence d'échantillonnage.

Les transformateurs de Hilbert dont la structure va être décrite sont caractérisés par le fait qu'ils effectuent une quadrature exacte entre leurs signaux de sortie, et que la précision de la transformation dépend de la précision de la réponse amplitude-fréquence, laquelle permet de définir une certaine bande utile pour le transformateur.

Les exemples qui suivent correspondent à des transformateurs caractérisés par le fait que, tout en étant précis aux environs de 0,1dB sur une large bande, leurs coefficients sont en nombre réduit et sont simples. Ceux-ci ne comportent en effet que peu d'éléments binaires égaux à l'unité. Ainsi, tous les coefficients ne comportant que deux éléments binaires égaux à l'unité peuvent être réalisés au moyen d'additionneurs.

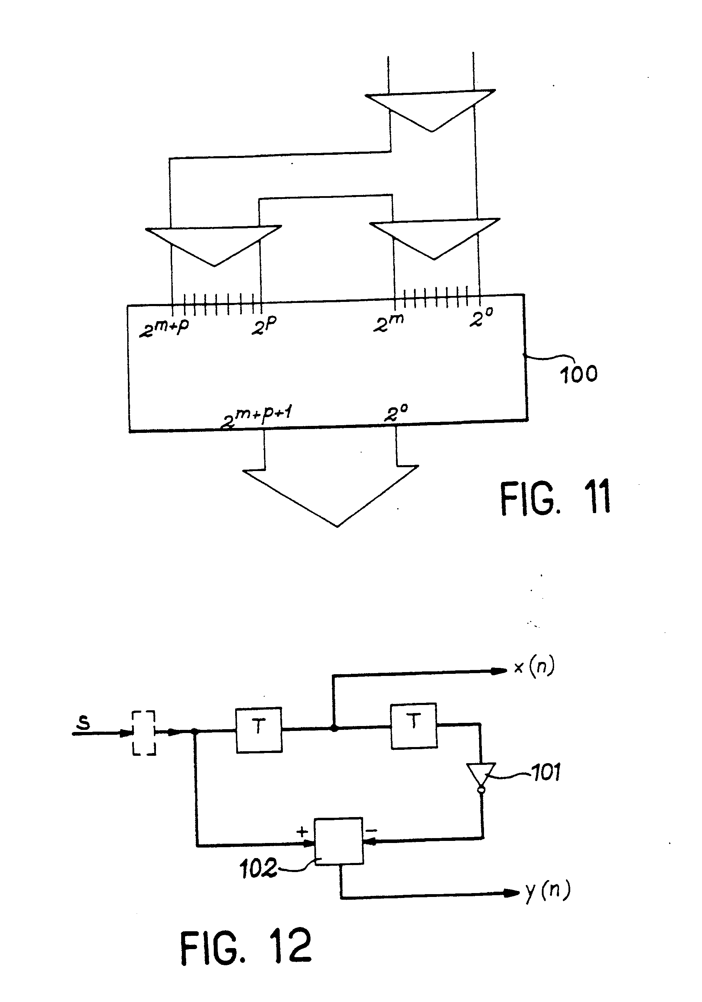

De façon plus précise, il s'agit de multiplier une grandeur d'entrée $\underline{e}$ par un nombre $\underline{a}$ comportant deux éléments binaires égaux à 1 ; ce nombre s'écrit a $= 2^q+2^p$. Par exemple si q $= 0$, on a $\underline{a} = 2^0+2^p$. Cette multiplication peut être réalisée par un additionneur 100 tel que représenté sur la figure 11. Les entrées de $2^0$ à $2^m$ reçoivent le signal $\underline{e}$ supposé à m+1 bits, lequel est appliqué aussi sur l'autre voie de l'additionneur, aux entrées de poids $2^p$ à $2^{m+p}$. La sortie délivre le signal $e(2^0+2^p)$.

Par exemple, avec a=5 on a bien deux éléments binaires égaux à 1 : $1+2^2 = 101$ et l'on pourra réaliser la multiplication par 5 par un additionneur à deux groupes d'entrées décalées de 2.

Le tableau suivant donne quelques exemples de transformateurs de Hilbert. Dans ce tableau, la notation TH désigne le type de transformateur (4 types sont prévus), la valeur du coefficient multiplieur x, la valeur des coefficients $a_1$, $a_3$, $a_5$, $a_6$, le nombre n d'éléments binaires égaux à 1 pour chaque coefficient (par exemple pour un coefficient égal à 12, on a 12 = 1100, donc n = 2). Lorsque ce nombre n'excède pas 2, on pourra utiliser des additionneurs (Add) comme expliqué à propos de la figure 11, sinon on utilisera des mémoires mortes (MM). Le tableau donne enfin les performances obtenues.

T A B L E A U   1

| Transformateur | | Coefficients | | | | Performances |
|---|---|---|---|---|---|---|
| | | $a_1$ | $a_3$ | $a_5$ | $a_7$ | |
| TH 1 | Valeurs x 1/256 | 157 | 39 | 12 | 3 | Réponse entre 0dB et - 0,1dB |
| | n | 5 | 4 | 2 | 2 | de 0,1 fe à 0,4 fe |
| | Réalisation | MM | MM | Add | Add | |
| TH 2 | Valeurs x 1/128 | 78 | 18 | 5 | 1 | Réponse entre + 0,02 dB et -0,1 dB |
| | n | 4 | 2 | 2 | 1 | |
| | Réalisation | MM | Add | Add | - | de 0,116 fe à 0,384 fe |
| TH 3 | Valeurs x 1/128 | 78 | 17 | 4 | | Réponse entre + 0,13 dB et - 0,13 dB |
| | n | 4 | 2 | 1 | | de 0,107 fe à 0,393 fe |
| | Réalisation | MM | Add | - | | |
| TH 4 | Valeurs 1/64 | 37 | 5 | | | Réponse entre 0 dB et - 0,5 dB |
| | n | 3 | 2 | | | de $\frac{fe}{8}$  à  $\frac{3fe}{8}$ |
| | Réalisation | MM | Add | | | |

Les exemples particuliers qui suivent concernent des transformateurs de structure simple qui s'appliquent entre autres à la démodulation des signaux de télévision en couleur SECAM, PAL et NTSC.

Dans tout ce qui suit, on désignera par T, 2T, 3T, etc. des lignes à retard introduisant des retards d'une, deux, trois etc. périodes d'échantillonnage et par $R_1$, $R_2$, $R_3$ etc. des registres optionnels. Le premier exemple particulier concerne un transformateur de Hilbert obtenu par simple moyenne (un seul coefficient $a_1$ = 1/2). Ce dispositif est applicable dans toutes les hypothèses où le signal modulé occupe une bande de fréquence au voisinage du quart de la fréquence d'échantillonnage telle que dans le cas du signal de chrominance du système NTSC échantillonné à une fréquence de 13,5MHz. Sa réponse est comprise entre 0dB et −0,1dB pour des fréquences comprises entre 0,226 fe et 0,274 fe. La figure 12 en donne une représentation. Il comprend deux lignes à retard T, un inverseur 101 et un soustracteur 102.

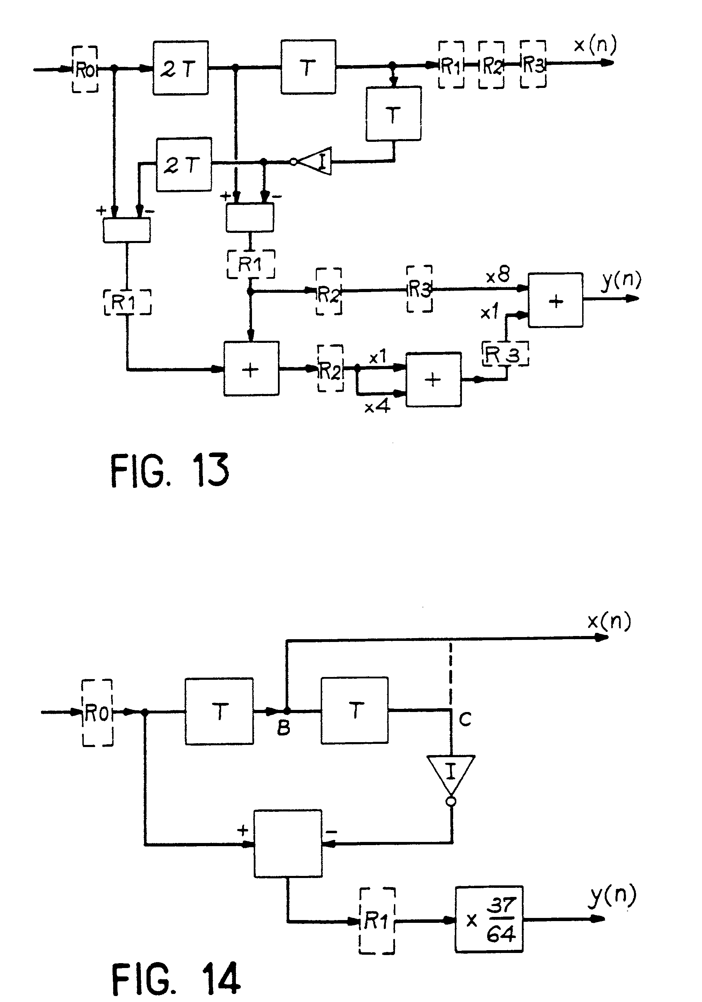

Dans des contextes de ce type, des performances supérieures peuvent être obtenues pour de larges gammes de fréquences d'échantillonnage en utilisant les transformateurs apparaissant au tableau 1 ci-joint aux références TH3 et TH4. La figure 13 donne une réalisation particulière du transformateur TH4 n'utilisant que des additionneurs et mettant à profit le fait que les coefficients pouvant s'écrire $a_1$ = 1/2 + 5/64 et $a_2$ = 5/64, il est possible d'utiliser le coefficient 5 comme facteur commun.

Sur la figure 13, $R_0$, $R_1$, $R_2$, $R_3$ sont des registres optionnels. Les registres $R_1$, $R_2$, $R_3$ délivrant x(n), lorsqu'ils ne sont pas par ailleurs nécessaires, peuvent être évités en prenant x(n) en des points intermédiaires entre les éléments de retard T, 2T et en veillant à conserver la polarité correcte des données.

Un dernier type particulier de transformateur s'applique dans ce cadre aux signaux SECAM et PAL échantillonnés à la fréquence de 13,5MHz. Il est alors possible d'effectuer une transformation à un seul cofficient :

$a_1 = 37/64$. La réponse de celle-ci reste suffisamment proche de l'unité dans la bande utile des signaux de chrominance pour conserver des performances suffisantes. La figure 14 donne une représentation de ce transformateur,

Sur cette figure 14, les registres $R_0$ et $R_1$ sont optionnels. Lorsqu'un registre $R_1$ est nécessaire, la sortie de x(n) se fait non plus au point B mais au point C.

L'élément noté x(37/64) est constitué soit d'une mémoire morte, soit de deux étages d'additionneurs dont le premier, en appelant e la donnée d'entrée, calcule e+4e=5e et le second 5e+32e=37e.

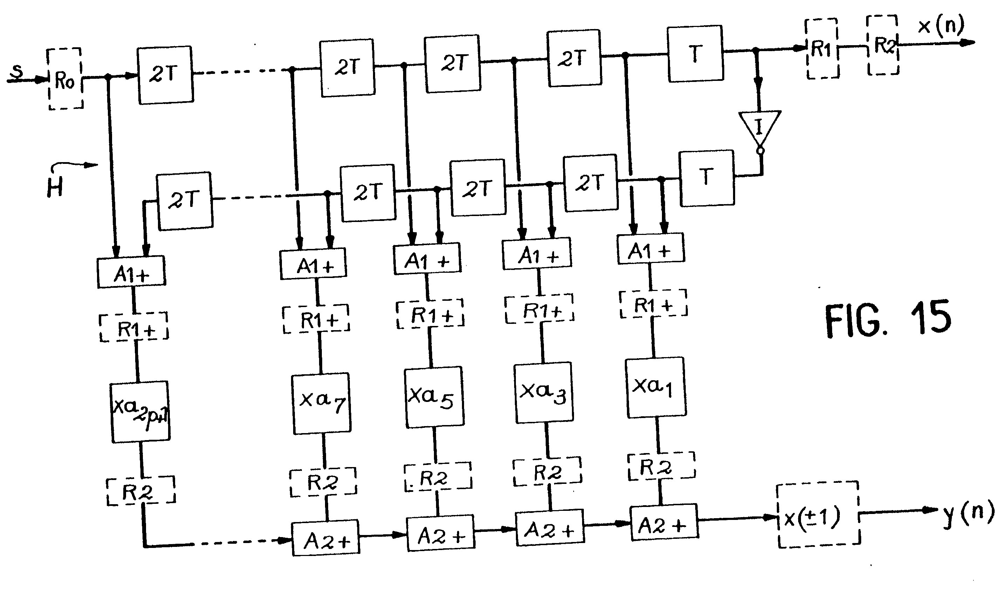

Les figures 15, 16 et 17 illustrent trois structures de base utilisables dans la présente invention pour constituer le transformateur de Hilbert.

Ces trois variantes ont des structures assez similaires. Elles comportent :
– un registre d'entrée $R_0$ optionnel destiné a prendre en compte les données d'entrée,
– une ligne à retard de distribution des données d'entrée constituée de registres permettant, selon le besoin, de décaler les données d'entrée de T, 2T, 3T ou 4T, T étant la periode du signal d'horloge alimentant le dispositif,
– un inverseur 1, au besoin intégré au registre qui précède (figures 14, 16, 17) auquel cas l'inversion doit être compensée pour sortir les données x(n) avec la bonne polarité, ou au registre qui suit (figure 15). Cet inverseur a pour but, les données d'entrée étant codées sous forme "complément à 2", de préparer l'inversion de signe de celles-ci qui sera achevée en ajoutant un "1" (niveau haut binaire) au niveau de l'élément binaire de poids faible de chacun des additionneurs A1,
– un ensemble d'additionneurs AI permettant d'effectuer la soustraction entre une donnée d'entrée et une autre retardée d'un certain nombre de périodes d'horloge,
– un ensemble d'opérations $Xa_{2p+1}$ chargé d'effectuer le produit du signal sortant d'un additionneur A1 afférent à ce coefficient ; ces opérateurs seront réalisés au moyen d'additionneurs ou de mémoires mortes comme expliqué plus haut,
– éventuellement des regitres $R_1$ et $R_2$ qui, pour des versions rapides du système, sont destinés à masquer les temps de transit dans les circuits qui les précèdent ; les retards introduits par ces registres sont compensés par des registres identiques placés sur la sortie délivrant les données x(n),
– une série d'additionneurs A2 éventuellement séparés par des registres introduisant des retards T ou 2T, destinés à sommer l'ensemble des résultats des calculs conduisant aux données y(n),
– éventuellement un dispositif de sortie permettant de changer le signe de y(n) et, par là même, le sens de la quadrature (avant ou arrière) de ces données par rapport aux données x(n).

La différence entre ces trois variantes tient uniquement à la répartition des éléments de retard des données d'entrée et des données de sortie (registre séparant les additionneurs A2).

Le transformateur de la figure 15 est celui qui, pour un nombre de coefficients donné, demande le nombre total d'éléments de retard le moins élevé. Il suppose par contre des circuits rapides, c'est-à-dire en mesure d'effectuer l'ensemble des additions faites par les additionneurs A2 en moins d'une période d'horloge.

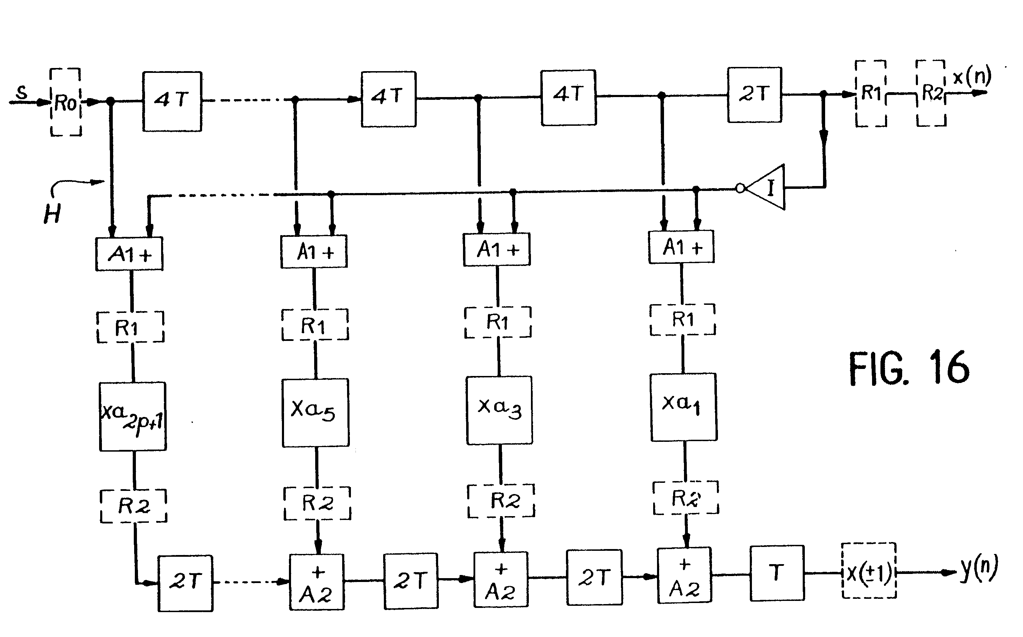

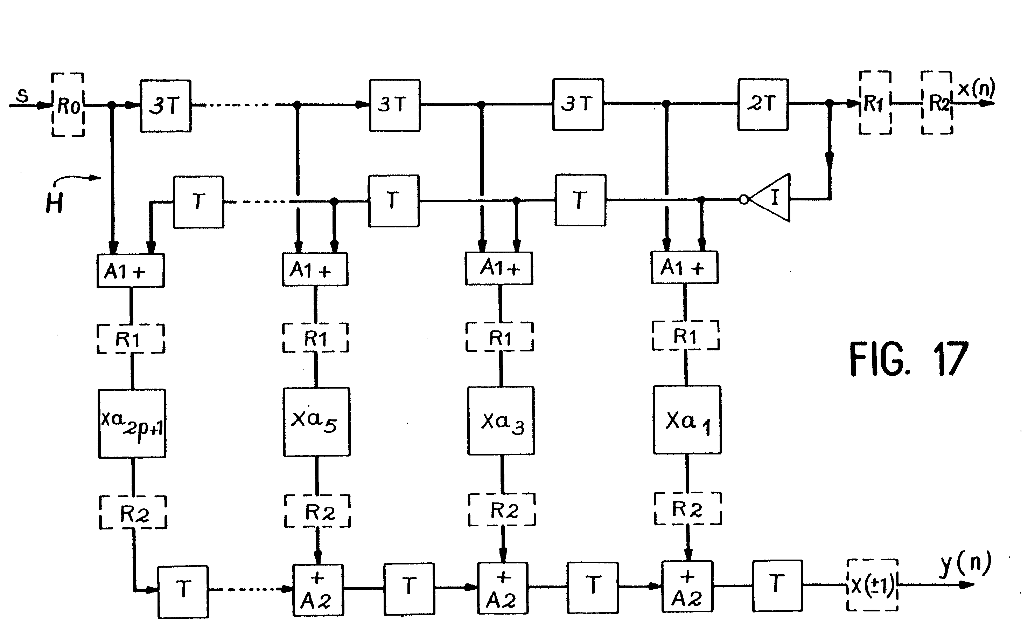

Les structures données aux figures 16 et 17 ne présentent pas ces exigences de vitesse. La figure 16 conduit au nombre de registres le plus élevé, la distribution plus simple des données d'entrée des additionneurs A1 peut, par contre, s'y avérer attrayante.

## Revendications

1. Double démodulateur numérique, comprenant :
– une entrée générale (10) recevant des échantillons numériques s(n) d'un signal modulé, où n est le rang de l'échantillon,
– un transformateur de Hilbert (20) ayant une entrée reliée à l'entrée générale (10) et une première et une seconde sorties (21, 22) délivrant respectivement des échantillons en quadrature x(n+1) et y(n+1),
– un circuit de régénération de porteuse (30) ayant une entrée reliée à l'entrée générale (10) et une première et une seconde sorties (31, 32) délivrant des sous-porteuses en quadrature X(n+1) et Y(n+1),
– une première ligne à retard (35) reliée à l'une des deux sorties (21 ou 22) du transformateur de Hilbert (20) et délivrant un échantillon retardé x(n) ou y(n) d'une période d'échantillonnage,
– une seconde ligne à retard (36) reliée à l'autre sortie (22) du transformateur de Hilbert (20) et délivrant un échantillon retardé y(n) ou x(n) d'une période d'échantillonage,
– un premier dispositif de commutation (38) ayant une première entrée (A) reliée à la seconde sortie (32) du circuit de régénération de porteuse (30), une seconde entrée (F) reliée à la première ligne à retard (35) et une sortie,
– un second dispositif de commutation (39) ayant une première entrée (A) reliée, par l'intermédiaire d'un inverseur (34), à la première sortie (31) du circuit de régénération de porteuse (30), une seconde entrée (F) reliée à la seconde ligne à retard (36) et une sortie,

– un premier multiplieur (40) ayant une première entrée reliée à la sortie du premier dispositif de commutation (38) et recevant l'échantillon x(n) ou y(n) ou la sous-porteuse Y(n+1), et une seconde entrée reliée à la première sortie (21) du transformateur de Hilbert (20) et recevant l'échantillon x(n+1), ce premier multiplieur ayant une sortir délivrant l'un des produits y(n)x(n+1), x(n)x(n+1), x(n+1)Y(n+1),

– un second multiplieur (42) ayant une première entrée reliée à la sortie du second dispositif de commutation (39) et recevant l'échantillon y(n) ou x(n) ou la sous-porteuse –X(n+1)et une seconde entrée reliée à la seconde sortie (22) du transformateur de Hilbert (20) et recevant l'échantillon y(n+1), ce second multiplieur (42) ayant une sortie délivrant l'un des produits x(n)y(n+1), y(n)y(n+1), –y(n+1)X(n+1),

– un premier additionneur (44) ayant une première entrée reliée à la sortie du premier multiplieur (40) et une seconde entrée pouvant être inverseuse reliée à la sortie du second multiplieur (42), ce premier additionneur ayant une sortie délivrant un signal $E_0(n)$ ou $E_1(n)$ ou V(n+1),

– un troisième dispositif de commutation (46) ayant une première entrée (F) reliée à la première sortie (21) du transformateur de Hilbert (20) et une seconde entrée (A) reliée à la première sortie (31) du circuit de régénération de porteuse (30), et une sortie,

– un troisième multiplieur (48) ayant une première entrée reliée à la première sortie (21) du transformateur de Hilbert (20), une seconde entrée reliée à la sortie du troisième dispositif de commutation (46), et une sortie délivrant soit $x^2(n+1)$, soit x(n+1)X(n+1),

– un quatrième dispositif de commutation (50) ayant une première entrée (F) reliée à la seconde sortie (22) du transformateur de Hilbert (20), une seconde entrée reliée à la seconde sortie (32) du circuit de régénération de porteuse (30) et une sortie,

– un quatrième multiplieur (52) ayant une première entrée reliée à la seconde sortie (22) du transformateur de Hilbert (20), une seconde entrée reliée à la sortie du quatrième dispositif de commutation (50) et une sortie délivrant soit y(n+1), soit y(n+1)Y(n+1),

– un second additionneur (54) ayant une première entrée reliée à la sortie du troisième multiplieur (48), une seconde entrée reliée à la sortie du quatrième multiplieur (52) et une sortie délivrant une quantité M(n+1), ou U(n+1),

– éventuellement une troisième ligne à retard (56) d'une période d'échantillonnage reliée au second additionneur (54) et délivrant le signal M(n),

– un circuit diviseur (60) ayant une première entrée reliée à la sortir du premier additionneur (44) et recevant un signal $E_0(n)$ ou $E_1(n)$, une seconde entrée reliée à la troisième ligne à retard (56) ou, si celle-ci n' existe pas, au second additionneur (54) et recevant le signal M(n) et une sortie délivrant un signal quotient de $E_0(n)$ ou $E_1(n)$ par M(n) ou le logarithme de ce rapport,

– un circuit de sortie (62) ayant une entrée adressée par le signal apparaissant à la sortie du circuit diviseur (60) et une sortie,

ce démodulateur étant capable de démoduler :

– soit un signal s(n) modulé en fréquence ou en phase et en amplitude par un signal modulant m(n), auquel cas les quatre dispositifs de commutation (38, 39, 46, 50) sont dans la position qui relie leur sortie à leur première entrée (F), le signal modulant m(n) étant alors disponible sur une sortie générale (64) reliée à la sortie du circuit de sortie (62), l'amplitude étant disponible, par son carré, à la sortie (68) du second additionneur (54),

– soit un signal à double modulation d'amplitude U(n), V(n) en quadrature et à porteuse supprimée, auquel cas les quatre dispositifs de commutation (38, 39, 46, 50) sont dans la position qui relie leur sortie à leur seconde entrée (A), les signaux démodulés V(n+1) et U(n+1) étant disponibles sur deux sorties générales (66,68) correspondant respectivement à la sortie du premier (44) et du second (54) additionneurs.

2. Double démodulateur numérique selon la revendication 1, caractérisé par le fait que le circuit diviseur (60) comprend une mémoire morte (63) recevant le signal M(n) comme adresse et délivrant le signal inverse 1/M(n) et un multiplieur (61) à deux entrées, l'une recevant E(n) et l'autre 1/M(n) et à une sortie délivrent le rapport E(n)/M(n).

3. Double démodulateur numérique selon la revendication 1, caractérisé par le fait que le circuit diviseur (60) comprend deux mémoires aortes (72 et 73), la première recevant E(n) et la seconde M(n) et délivrant respectivement le logarithme à base 2 de la valeur absolue de E(n) et le logarithme de M(n), et un soustracteur (71) recevant ces logarithmes et délivrant, d'une part, le logarithme du quotient et, d'autre part, un signal définissant le signe de E(n).

4. Double démodulateur numérique selon la revendication 1, caractérisé par le fait que le circuit diviseur (60) comprend une première mémoire morte (72) recevant E(n) et délivrant le logarithme de cette quantité, soit logE(n), une seconde mémoire morte (73) recevant M(n+1) et délivrant le logarithme de cette quantité, soit

logM(n+1), une ligne à retard d'une période (76) recevant logM(n+1) et délivrant logM(n), un additionneur (75) recevant logM(n) et logM(n+1) et délivrant la demi-somme de ces logarithmes, un soustracteur (77) recevant ladite demi-somme sur l'entrée négative et logE(n) sur l'entrée positive et délivrant un signal appliqué sur le circuit de sortie (62).

## Ansprüche

1. Zweifacher digitaler Demodulator mit

– einem Haupteingang (10), der digitale Teilsignale s(n) eines modulierten Signals emfpängt, wobei $\underline{n}$ der Grad der Entwicklung des Signals ist,

– einem Hilbert-Transformator (20) mit einem mit dem Haupteingang (10) verbundenen Eingang und einem ersten und einem zweiten Ausgang (21, 22), die jeweils um 90° phasenverschobene Teilsignale x(n+1) und y(n+1) abgeben,

– einem Trägersignal-Regenerationskreis (30) mit einem mit dem Haupteingang (10) verbundenen Eingang und einem ersten und einem zweiten Ausgang (31, 32), die um 90° phasenverschobene Hilfsträgersignale X(n+1) und Y(n+1) abgeben,

– einer ersten Verzögerungsleitung (35), die mit einem der beiden Ausgänge (21 oder 22) des Hilbert-Transformators (20) verbunden ist und ein verzögertes Teilsignal x(n) oder y(n) mit einer Periode der Signalunterteilung abgibt,

– einer zweiten Verzögerungsleitung (36), die mit dem anderen Ausgang (22) des Transformators verbunden ist und ein verzögertes Teilsignal y(n) oder x(n) mit einer Periode der Signalunterteilung abgibt,

– einer ersten Umschalteinrichtung (38) mit einem ersten Eingang (A), der mit dem zweiten Ausgang (32) des Trägersignal-Regenerationskreises (30) verbunden ist, wobei ein zweiter Ausgang (F) mit der ersten Verzögerungsleitung (35) und einem Ausgang verbunden ist,

– einer zweiten Umschalteinrichtung (39) mit einem ersten Eingang (A), der über einen Inverter (34) mit dem ersten Ausgang (F) des TrägersignalRegenerationskreises (30) verbunden ist, wobei ein zweitern Eingang (F) mit der zweiten Verzbgerungsleitung (36) und einem Ausgang verbunden ist,

– einer ersten Multiplikationsschaltung (40) mit einem ersten Eingang, der mit dem Ausgang der ersten Umschalteinrichtung (38) verbunden ist und das Teilsignal x(n) oder y(n) oder das Hilfsträgersignal Y(n+1) empfängt, und mit einem zweiten Eingang, der mit dem ersten Ausgang (21) des Hilbert-Transformators (20) verbunden ist und das Teilsignal x(n+1) empfängt, wobei die erste Multiplikationsschaltung einen Ausgang aufweist, der eines der Produkte y(n)x(n+1), x(n)x(n+1), x(n+1)Y(n+1) abgibt,

– einer zweiten Multiplikationsschaltung (42) mit einem ersten Eingang, der mit dem Ausgang der zweiten Umschalteinrichtung (39) verbunden ist und das Teilsignal y(n) oder x(n) oder das Hilfsträgersignal X(n+1) empfängt, und mit einem zweiten Eingang, der mit dem zweiten Ausgang (22) des Hilbert-Transformators verbunden ist und das Teilsignal y(n+1) empfängt, wobei die zweite Multiplikationsschaltung (42) einen Ausgang aufweist, der eines der Produkte x(n)y(n+1), y(n)y(n+1), −y(n+1)X(n+1) abgibt,

– einer ersten Additionsschaltung (44) mit einem ersten Eingang, der mit dem Ausgang der ersten Multiplikationsschaltung (40) verbunden ist, und mit einem zweiten Eingang, der invertiert an den Ausgang der zweiten Multiplikationsschaltung (42) angeschlossen werden kann, wobei die erste Additionsschaltung einen Ausgang aufweist, der ein Signal $E_0(n)$ oder $E_1(n)$ oder V(n+1) abgibt,

– einer dritten Umschalteinrichtung (46) mit einem ersten Eingang (F), der mit dem ersten Ausgang (21) des Hilbert-Transformators (20) verbunden ist, und mit einem zweiten Eingang (A), der mit dem ersten Ausgang (31) des Trägersignal-Regenerationskreises (30) verbunden ist, und mit einem Ausgang,

– einer dritten Multiplikationsachaltung (48) mit einem ersten Eingang, der mit dem eraten Ausgang (21) des Hilbert-Transformators (20) verbunden ist, mit einem zweiten Eingang, der mit dem Ausgang der dritten Umschalteinrichtung (46) verbunden ist, und mit einem Ausgang, der entweder $x^2(n+1)$ oder x(n+1)X(n+1) abgibt,

– einer vierten Umschalteinrichtung (50) mit einem ersten Eingang (F), der mit dem zweiten Ausgang (22) des Hilbert-Transformators (20) verbunden ist, mit einem zweiten Eingang, der mit dem zweiten Ausgang (32) des Trägersignal-Regenerationskreises (30), und mit einem Eingang,

– einer vierten Multiplikationsschaltung (52) mit einem ersten Eingang, der mit dem zweiten Ausgang (22) des Hilbert-Transformators verbunden ist, mit einem zweiten Eingang, der mit dem Ausgang der vierten Umschalteinrichtung (50) verbunden ist, und mit einem Ausgang, der entweder y(n+1) oder y(n+1)Y(n+1) abgibt,

– einer zweiten Additionsschaltung (54) mit einem ersten Eingang, der mit dem Ausgang der dritten Multiplikationsschaltung (48) verbunden ist, mit einem zweiten Eingang, der mit dem Ausgang der vierten Multiplikationsschaltung (52) verbunden ist, und mit einem Ausgang, der ein Signal M(n+1) oder U(n+1) abgibt,
– gegebenenfalls einer dritten Verzögerungsleitung (56) mit einer Periode der Signalunterteilung, die mit der zweiten Additionsschaltung (54) verbunden ist und das Signal M(n) abgibt,
– einer Divisionsschaltung (60) mit einem ersten Eingang, der mit dem Ausgang der ersten Additionsschaltung (44) verbunden ist und das Signal $E_0(n)$ oder $E_1(n)$ empfängt, mit einem zweiten Eingang, der mit der dritten Verzögerungsleitung (56) oder, falls eine solche nicht vorhanden ist, mit der zweiten Additionsschaltung (54) verbunden ist und das Signal M(n) empfängt, und einem Ausgang, der ein Quotientensignal aus $E_0(n)$ oder $E_1(n)$ mit M(n) oder den Logarithmus dieses Verhältnisses abgibt,
– einem Ausgangskrels (62) mit einem Eingang, der von dem am Ausgang der Divisionsschaltung (60) erscheinenden Signal angesteuert wird, und mit einem Ausgang,
wobei der Demodulator demodulieren kann :
– entweder ein Signal s(n), dessen Frequenz oder Phase oder Amplitude durch ein Modulationsignal m(n) moduliert ist, wobei sich in diesem Fall die vier Umschalteinrichtungen (38, 39, 46, 50) in der Stellung befinden, in der ihr Ausgang mit ihrem ersten Eingang (F) verbunden ist, wobei das Modulationssignal m(n) dann an einem Hauptausgang (64) verfügbar ist, der mit dem Ausgang des Ausgangskreises (62) verbunden ist, wobei die Amplitude im Quadrat am Ausgang (68) der zweiten Additionsschaltung (54) verfügbar ist,
– oder ein zweifach amplituden-moduliertes Signal U(n), V(n) um 90° phasenverschoben und mit unterdrückter Trägerwelle, wobei sich in diesem Fall die vier Umschalteinrichtungen (38, 39, 46, 50) in dem Zustand befinden, in dem ihr Ausgang mit ihren zweiten Eingängen (A) verbunden ist, wobei die demodulierten Signale V(n+1) und U(n+1) an zwei Hauptausgängen (66, 68), die jeweils dem Ausgang der ersten (44) bzw. der zweiten (54) Additionsschaltung entsprechen, verfügbar sind.

2. Zweifacher digitaler Demodulator nach Anspruch 1, **dadurch gekennzeichnet, daß** die Divisionsschaltung (60) einen Festwertspeicher (63), der das Signal M(n) als Adresse empfängt und das inverse Signal 1/M(n) abgibt, und eine Multiplikationsschaltung (61) mit zwei Eingängen aufweist, von denen einer das Signal E(n) und der andere 1/M (n) empfängt und an einem Ausgang das Signal für das Verhältnis E(n)/M(n) abgibt.

3. Zweifacher digitaler Demodulator nach Anspruch 1, **dadurch gekennzeichnet, daß** die Divisionsschaltung (60) zwei Festwertspeicher (72 und 73), von denen der erste das Signal E(n) und der zweite das Signal M(n) empfängt und entsprechend das Signal für den Zweierlogarithmus des Absoluten Wertes von E(n) und den Logarithmus von M(n) abgibt, und eine Subtrahierschaltung (71) aufweist, die diese Logarithmussignale empfängt und einerseits das Signal für den Logarithmus des Quotienten und andererseits ein das Vorzeichen von E(n) definierendes Signal abgibt.

4. Zweifacher digitaler Demodulator nach Anspruch 1, **dadurch gekennzeichnet, daß** die Divisionsschaltung (60) einen ersten Festwertspeicher (72), der das Signal E(n) empfängt und das Logarithmussignal für diese Größe abgibt, nämlich logE(n), einen zweiten Festwertspeicher (73), der das Signal M(n+1) empfängt und das Logarithmussignal für diesen Wert abgibt, nämlich logM(n+1), eine Verzögerungsleitung (76) für eine Periode, die das Signal logM(N+1) empfängt und das Signal logM(n) abgibt, eine Additionsschaltung (75), die das Signal logM(n) und logM(n+1) empfängt und das Signal für die halbe Summe dieser Logarithmen abgibt, und eine Subtrahierschaltung (77) aufweist, die am negativen Eingang das Halbsummen-Signal und am positiven Eingang das Signal logE(n) empfängt und ein an den Ausgangskreis (62) anzulegendes Signal abgibt.


## Claims

1. Double digital demodulator, comprising :
– a general input (10) receiving the digital samples s(n) of a modulated signal, in which $\underline{n}$ is the rank of the sample ;
–a Hilbert transformer (20) having an input connected to the general input (10) and first and second outputs (21, 22) respectively supplying samples in quadrature x(n+1) and y(n+1) ;
– a carrier regenerating circuit (30) having an input connected to the general input (10) and first and second outputs (31, 32) supplying subcarriers in quadrature X(n+1) and Y(n+1) ;
– a first delay line (35) connected to one of the two outputs (21 or 22) of Hilbert transformer (20) and supplying a delayed sample x(n) or y(n) of a sampling period ;
– a second delay line (36) connected to the other output (22) of the Hilbert transformer (20) and supplying a delayed sample y(n) or x(n) of a sampling period :
– a first switching device (38) having a first input (A) connected to the second output (32) of the carrier regenerating circuit (30), a second input (F) connected to the first delay line (35) and an output ;
– a second switching device (39) having a first input (A) connected, via an inverter or NOT circuit (34), to the first output (31) of the carrier regenerating circuit (30), a second input (F) connected to the second delay

EP 0 259 419 B1

line (36) and an output (S) ;

– a first multiplier (40) having a first input connected to the output of the first switching device (38) and receiving the sample x(n) or y(n) or the subcarrier Y(n+1) and a second input connected to the first output (21) of the Hilbert transformer (20) and receiving the sample x(n+1), said first multiplier having an output supplying one of the products y(n)x(n+1), x(n)x(n+1), x(n+1)Y(n+1) ;

– a second multiplier (42) having a first input connected to the output of the second switching device (39) and receiving the sample y(n) or x(n) or the subcarrier X(n+1) and a second input connected to the second output (22) of the Hilbert transformer (20) and receiving the sample y(n+1), said second multiplier (42) having an output supplying one of the products x(n)y(n+1), y(n)y(n+1), $-y(n+1)X(n+1)$ ;

– a first adder (44) having a first input connected to the output of the first multiplier (40) and a second input which can be inverting and connected to the output of the second multiplier (42), said first adder having an output supplying a signal $E_0(n)$ or $E_1(n)$ or V(n+1) ;

– a third swithching device (46) having a first input (F) connected to the first output (21) of Hilbert transformer (20) and a second input (A) connected to the first output (31) of the carrier regenerating circuit (30) and an output ;

– a third multiplier (48) having a first input connected to the first output (21) of the Hilbert transformer (20), a second input connected to the output of the third switching device (46) and an output supplying either $x^2(n+1)$ or x(n+1)X(n+1) ;

– a fourth switching device (50) having a first input (F) connected to a second output (22) of the Hilbert transformer (20), a second input connected to the second output (32) of the carrier regenerating circuit (30) and an output ;

– a fourth multiplier (52) having a first input connected to the second output (22) of the Hilbert transformer (20), a second input connected to the output of the fourth switching device (50) and an output supplying either y(n+1), or y(n+1)Y(n+1) ;

– a second adder (54) having a first input connected to the output of the third multiplier (48), a second input connected to the output of the fourth multiplier (52) and an output supplying a quantity M(n+1) or U(n+1) ;

– optionally a third delay line (56) for a sampling period connected to the second adder (54) and supplying the signal M(n) ;

– a divider circuit (60) having a first input connected to the output of the first adder (44) and receiving a signal $E_0(n)$ or $E_1(n)$, a second input connected to the third delay lie (56) or, if the latter does not exist, to the second adder (54) and receiving the signal M(n) and an output supplying a quotient signal of $E_0(n)$ or $E_1(n)$ by M(n) or the logarithm of this ratio ;

– an output circuit (62) having an input addressed by the signal appearing at the output of the divider circuit (60) and an output ;

said demodulator being able to demodulate :

– either a signal s(n) modulated in frequency or in phase and in amplitude by a modulating signal m(n), in which case the four switching devices (38, 39, 46, 50) are in the position connecting their output to the first input (F), the modulating signal m(n) then being available on a general output (64) connected to the output of output circuit (62), the amplitude being available by its square, at the output (68) of the second adder (54),

– or a double modulation amplitude signal U(n), V(n) in quadrature and with suppressed carrier, in which case the four switching devices (38, 39, 46, 50) are in the position connecting their output to the second input (A), the demodulated signals V(n+1) and U(n+1) being available on two general outputs (66, 68) respectively corresponding to the output of the first (44) and the second (54) adders.

2. Double digital demodulator according to claim 1, characterized in that the divider circuit (60) comprises a read-only memory (63) receiving the signal M(n) as the address an supplying the reverse signal 1/M(n) and a multiplier (61) with two inputs, one receiving E(n) and the other 1/M(n) and an output supplying the ratio E(n)/M(n).

3. Double digital demodulator according to claim 1, characterized in that the divider circuit (60) comprises two read-only memories (72, 73), the first receiving E(n) and the second M(n) and respectively supplying the logarithm to base (2) of the absolute value of E(n) and the logarithm of M(n) and a subtractor (71) receiving these logarithms and supplying on the one hand the logarithm of the quotient and on the other a signal defining the sign of E(n).

4. Double digital demodulator according to claim 1, characterized in that the divider circuit (60) comprises a first read-only memory (72) receiving E(n) and supplying the logarithm of this quantity, i.e. logE(n), a second read-only memory (73) receiving M(n+1) and supplying the logarithm of said quantity, i.e. logM(n+1), a delay line by a period (76) receiving logM(n+1) and supplying logM(n), an adder (75) receiving logM(n) and logM(n+1) and supplying the half-sum of these logarithms, a subtractor (77) receiving said half-sum on the negative input

16

and logE(n) on the positive input and supplying a signal applied to the output circuit (62).

FIG. 1

FIG. 2

FIG. 3

de 44　　　　　　　　　　　de 54

E(n)　　　　　　　　　　　M(n)

61　　　63

1/M(n)

E(n)/M(n)

62

# FIG. 4

64

m(n)

de 44　　　　　　　　　　　de 54

E(n)　　　　　　　　　　　M(n)

72　　71　　73

$\log_2 |E(n)|$　　　　　　　　　　$\log_2 M(n)$

$\log_2 \dfrac{|E(n)|}{M(n)}$

signe de E(n)

60

62

# FIG. 5

64

m(n)

FIG. 6

FIG. 7

FIG. 8

FIG. 9

FIG. 10

FIG. 11

FIG. 12

FIG. 13

FIG. 14

FIG. 15

FIG. 16

EP 0 259 419 B1

FIG. 17

EP 0 259 419 B1